# EUROPEAN PATENT SPECIFICATION

(11) **EP 3 117 463 B1**
(45) Date of publication and mention of the grant of the patent: **08.12.2021**
(21) Application number: 15745260.8
(22) Date of filing: 12.01.2015
(51) Int. Cl.: H01L 29/16, H01L 29/10, H01L 29/739, H01L 21/331

(54) **IGBT STRUCTURE FOR WIDE BAND-GAP SEMICONDUCTOR MATERIALS**
IGBT-STRUKTUR FÜR BREITBANDLÜCKEN-HALBLEITERMATERIALIEN
STRUCTURE IGBT POUR MATÉRIAUX SEMI-CONDUCTEURS À LARGE BANDE INTERDITE

(30) Priority: 14.03.2014 US 201414212991
(43) Date of publication of application: 18.01.2017
(73) Proprietor: Wolfspeed, Inc., Durham, NC 27703 (US)
(72) Inventor: PALA, Vipindas, Morrisville, North Carolina 27560 (US); VAN BRUNT, Edward Robert, Raleigh, North Carolina 27606 (US); CHENG, Lin, Chapel Hill, North Carolina 27514 (US)
(74) Representative: Murgitroyd & Company
(86) International application number: PCT/US2015/011015
(87) International publication number: WO 2015/160393

(56) References cited:
- EP-A1- 1 965 432
- EP-A2- 2 581 939
- GB-A- 2 243 952
- US-A1- 2004 119 076
- US-A1- 2011 101 375
- US-A1- 2012 292 742
- TAMAKI T ET AL: "Optimization of on -State and Switching Performances for 15-20-kV 4H-SiC IGBTs", IEEE TRANSACTIONS ON ELECTRON DEVICES, IEEE SERVICE CENTER, PISACATAWAY, NJ, US, vol. 55, no. 8, 1 August 2008 (2008-08-01) , pages 1920-1927, XP011231879, ISSN: 0018-9383, DOI: 10.1109/TED.2008.926965

## Description

### Field of the Disclosure

The present disclosure relates to insulated gate bipolar transistor (IGBT) devices and structures.

### Background

EP 1965432 discloses an IGBT comprising: a substrate having a first conductivity type; a drift layer on the substrate and having a second conductivity type opposite the first conductivity type; a current suppressing layer on the drift layer, the current suppressing layer having the second conductivity type and having a doping concentration that is larger than a doping concentration of the drift layer; a well region in the current suppressing layer and having the first conductivity type, wherein the well region has a junction depth that is less than a thickness of the current suppressing layer, and wherein the current suppressing layer extends laterally beneath the well region; and an emitter region in the well region and having the second conductivity type.

Insulated gate bipolar transistors devices, i.e. IGBT, provided with current suppressing layers are also known from the documents US 2012/0292742 A1, US 2011/0101375 A1, US 2004/0119076 A1, EP 2 581 939 A2 and from a non patent literature "Optimization of on -State and Switching Performances for 15-20-kV 4H-SiC IGBTs", Tamaki T. et al, published in IEEE Transactions on Electron Devices, Volume: 55, Issue: 8, Aug. 2008.

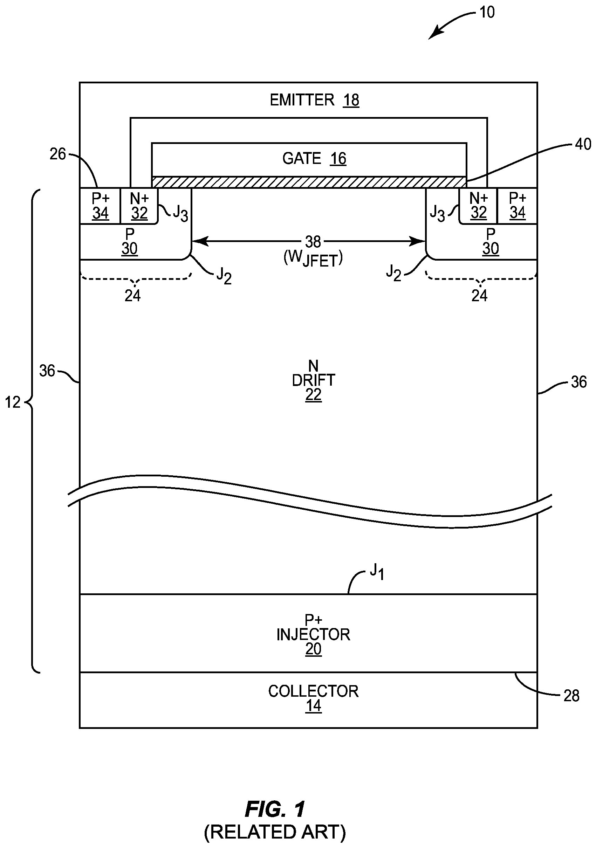

Document GB 2 243 952 A discloses a cellular insulated gate bipolar transistor device employing increased concentration in an active region between spaced base to a depth greater than the depth of the base regions. The insulated gate bipolar transistor (IGBT) is a semiconductor device that combines many of the desirable properties of a field-effect transistor (FET) with those of a bipolar junction transistor (BJT). An exemplary conventional IGBT device 10 is shown in Figure 1. The conventional IGBT device shown in Figure 1 represents a single IGBT cell that includes an IGBT stack 12, a collector contact 14, a gate contact 16, and an emitter contact 18. The IGBT stack 12 includes an injector region 20 adjacent to the collector contact 14, a drift region 22 over the injector region 20 and adjacent to the gate contact 16 and the emitter contact 18, and a pair of junction implants 24 in the drift region 22. The drift region 22 provides a first surface 26 of the IGBT stack 12 on which the gate contact 16 and the emitter contact 18 are located. Further, the injector region 20 provides a second surface 28 of the IGBT stack 12 opposite the first surface 26 on which the collector contact 14 is located.

Each one of the junction implants 24 is generally formed by an ion implantation process, and includes a base well 30, a source well 32, and an ohmic well 34. Each base well 30 is implanted in the first surface 26 of the IGBT stack 12, and extends down towards the injector region 20 along a lateral edge 36 of the IGBT stack 12. The source well 32 and the ohmic well 34 are formed in a shallow portion on the first surface 26 of the IGBT stack 12, and are surrounded by the base well 30. A JFET gap 38 separates each one of the junction implants 24, and defines a JFET gap width W_{JFET} as the distance between each one of the junction implants 24 in the conventional IGBT device 10.

A gate oxide layer 40 is positioned on the first surface 26 of the IGBT stack 12, and extends laterally between a portion of the surface of each one of the source wells 32, such that the gate oxide layer 40 partially overlaps and runs between the surface of each source well 32 in the junction implants 24. The gate contact 16 is positioned over the gate oxide layer 40. The emitter contact 18 is a "U" shape, and includes two portions in contact with the first surface 26 of the IGBT stack 12. Each portion of the emitter contact 18 on the first surface 26 of the IGBT stack 12 partially overlaps both the source well 32 and the ohmic well 34 of one of the junction implants 24, respectively, without contacting the gate contact 16 or the gate oxide layer 40.

A first junction J₁ between the injector region 20 and the drift region 22, a second junction J₂ between each base well 30 and the drift region 22, and a third junction J₃ between each source well 32 and each base well 30 are controlled to operate in one of a forward-bias mode of operation or a reverse-bias mode of operation based on the biasing of the conventional IGBT device 10. Accordingly, the flow of current between the collector contact 14 and the emitter contact 18 is controlled.

The conventional IGBT device 10 has three primary modes of operation. When a positive bias is applied to the gate contact 16 and the emitter contact 18, and a negative bias is applied to the collector contact 14, the conventional IGBT device 10 operates in a reverse blocking mode. In the reverse blocking mode of the conventional IGBT device 10, the first junction J₁ and the third junction J₃ are reverse-biased, while the second junction J₂ is forward biased. As will be understood by those of ordinary skill in the art, the reverse-biased junctions J₁ and J₃ prevent current from flowing from the collector contact 14 to the emitter contact 18. Accordingly, the drift region 22 supports the majority of the voltage across the collector contact 14 and the emitter contact 18.

When a negative bias is applied to the gate contact 16 and the emitter contact 18, and a positive bias is applied to the collector contact 14, the conventional IGBT device 10 operates in a forward blocking mode. In the forward blocking mode of the conventional IGBT device 10, the first junction J₁ and the third junction J₃ are forward biased, while the second junction J₂ is reverse-biased. As will be understood by those of ordinary skill in the art, the reverse-bias of the second junction J₂ generates a depletion region, which effectively pinches off the JFET gap 38 of the IGBT device 10 and prevents current from flowing from the collector contact 14 to the emitter contact 18. Accordingly, the drift region 22 supports the majority of the voltage across the collector contact 14 and the emitter contact 18.

When a positive bias is applied to the gate contact 16 and the collector contact 14, and a negative bias is applied to the emitter contact 18, the conventional IGBT device 10 operates in a forward conduction mode of operation. In the forward conduction mode of operation of the conventional IGBT device 10, the first junction J₁ and the third junction J₃ are forward-biased, while the second junction J₂ is reverse-biased. Accordingly, current can flow from the collector contact 14 to the emitter contact 18. Specifically, the positive bias applied to the gate contact 16 generates an inversion channel on the first surface 26 of the IGBT stack 12, thereby creating a low-resistance path for electrons to flow from the emitter contact 18 through each one of the source wells 32 and each one of the base wells 30 into the drift region 22. As electrons flow into the drift region 22, the potential of the drift region 22 is decreased, thereby placing the first junction J₁ in a forward-bias mode of operation. When the first junction J₁ becomes forward-biased, holes are allowed to flow from the injector region 20 into the drift region 22. The holes effectively increase the doping concentration of the drift region 22, thereby increasing the conductivity thereof. Accordingly, electrons from the emitter contact 18 may flow more easily through the drift region 22 and to the collector contact 14.

The IGBT stack 12 of the conventional IGBT device 10 is Silicon (Si), the advantages and shortcomings of which are well known to those of ordinary skill in the art. In an attempt to further increase the performance of IGBT devices, many have focused their efforts on using wide band-gap materials such as Silicon Carbide (SiC) for the IGBT stack 12. Although promising, conventional IGBT structures such as the one shown in Figure 1 are generally unsuitable for use with wide band-gap materials such as SiC. Due to inherent limitations in SiC fabrication processes, the carrier mobility and/or carrier concentration in the injector region 20 in a SiC IGBT device may be significantly diminished. Specifically, the conductivity in the injector region 20 will be low in a SiC device due to difficulties in growing high quality P-type epitaxial layers with low defect density. Further, due to damage in the drift region 22 caused by the ion implantation of the junction implants 24, the lifetime of carriers in the area directly below each junction implant 24 is significantly diminished. The result of the aforementioned conditions in a SiC IGBT device is that holes from the injector region 20 do not adequately modulate the conductivity of the portion of the drift region 22 above a certain distance from the injector region 20. Accordingly, electrons from the emitter contact 18 are met with a high-resistance path in the upper portion of the drift region 22, thereby increasing the on resistance R_{ON} of the conventional IGBT device 10 significantly, or cutting off current flow in the device altogether. Accordingly, an IGBT structure is needed that is suitable for use with wide band-gap semiconductor materials such as SiC.

### Summary

The present disclosure relates to an insulated gate bipolar transistor (IGBT) according to claim 1. According to one embodiment, an IGBT device includes an IGBT stack, a collector contact, a gate contact, and an emitter contact. The IGBT stack includes an injector region, a drift region over the injector region, a spreading region over the drift region, and a pair of junction implants in the spreading region. The spreading region provides a first surface of the IGBT stack, which is opposite the drift region. The pair of junction implants is separated by a JFET gap, and extends from the first surface of the IGBT stack along a lateral edge of the IGBT stack towards the drift region to a first depth, such that the thickness of the spreading region is at least two times greater than the first depth. By including the spreading layer that is substantially thicker than the depth of each junction implant, the ON resistance R_{ON} and front-side injection capabilities of the IGBT device may be improved.

According to one embodiment, the IGBT stack is formed of a wide band-gap semiconductor material. For example, the IGBT stack may be a Silicon Carbide (SiC) substrate.

According to one embodiment, the drift region is a lightly doped N region, the injector region is a highly doped P region, and the spreading region is a highly doped N region.

Those skilled in the art will appreciate the scope of the present disclosure and realize additional aspects thereof after reading the following detailed description of the preferred embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.

Figure 1 shows a two-dimensional representation of a conventional IGBT device.

Figure 2 shows a two-dimensional representation of an IGBT device suitable for wide band-gap semiconductor materials according to one embodiment of the present disclosure.

Figure 3 shows a flow-chart describing a method for manufacturing the IGBT device shown in Figure 2 according to one embodiment of the present disclosure.

Figures 4A-4I illustrate the method for manufacturing the IGBT device described in Figure 2 according to one embodiment of the present disclosure.

Figure 5 shows a two-dimensional representation of an IGBT device suitable for wide band-gap semiconductor materials according to one embodiment of the present disclosure.

Figure 6 shows a flow-chart describing a method for manufacturing the IGBT device shown in Figure 5 according to one embodiment of the present disclosure.

Figures 7A-7F illustrate the method for manufacturing the IGBT device described in Figure 5 according to one embodiment of the present disclosure.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the

Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

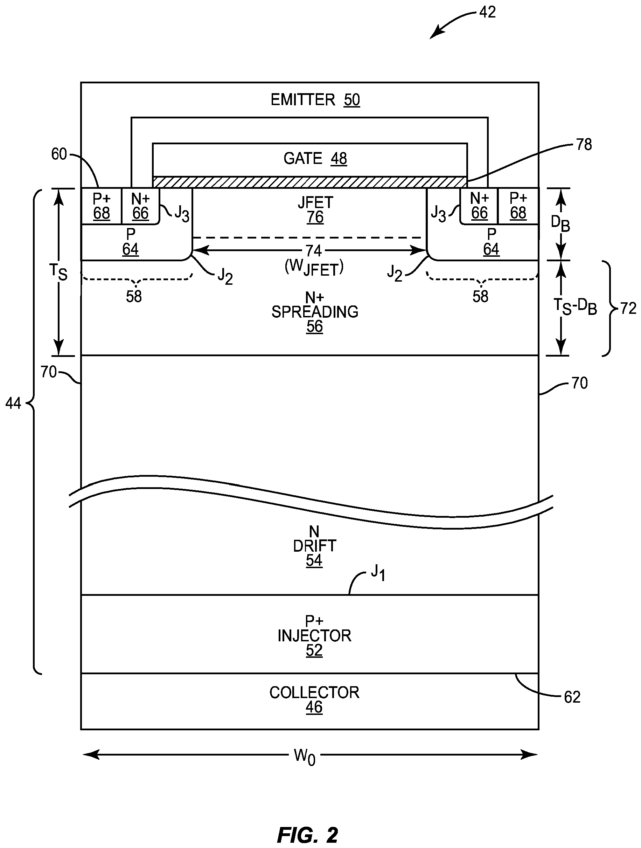

Turning now to Figure 2, an IGBT device 42 suitable for use with wide band-gap semiconductor materials systems is shown according to one embodiment of the present disclosure. The IGBT device 42 shown in Figure 2 represents a single IGBT cell, which may be part of a larger IGBT device including multiple cells. The IGBT device 42 includes an IGBT stack 44, a collector contact 46, a gate contact 48, and an emitter contact 50. The IGBT stack 44 includes an injector region 52 adjacent to the collector contact 46, a drift region 54 over the injector region 52, a spreading region 56 over the drift region 54 and adjacent to the gate contact 48 and the emitter contact 50, and a pair of junction implants 58 in the spreading region 56. The spreading region 56 provides a first surface 60 of the IGBT stack 44 on which the gate contact 48 and the emitter contact 50 are located. Further, the injector region 52 provides a second surface 62 of the IGBT stack 44 opposite the first surface 60 on which the collector contact 46 is located. A thickness (Ts) of the spreading region 56 is defined as the distance between the junction of the spreading region 56 and the drift region 54 and the first surface 60 of the IGBT stack 44.

Each one of the junction implants 58 may be formed by an ion implantation process, and may include a base well 64, a source well 66, and an ohmic well 68. Each base well 64 is implanted in the first surface 60 of the IGBT stack 44, and extends down towards the injector region 52 along a lateral edge 70 of the IGBT stack 44 to a first depth (D_{B}). Notably, the first depth (D_{B}) represents the portion of each junction implant 58 that is closest to the drift region 54, which is substantially less than the thickness (Ts) of the spreading region 56, thereby leaving a spreading layer buffer 72 between each one of the junction implants 58 and the drift region 54 in order to mitigate the effects of one or more damaged regions located below the junction implants 58, as discussed in further detail below. The thickness of the spreading layer buffer 72 is the thickness (Ts) of the spreading region 56 less the first depth (D_{B}) of the base well 64. The source well 66 and the ohmic well 68 are formed in a shallow portion of the first surface 60 of the IGBT stack 44, and are surrounded by the base well 64. A JFET gap 74 separates each one of the junction implants 58, and defines a JFET gap width W_{JFET} as the distance between each one of the junction implants in the IGBT device 42. An additional junction field-effect transistor (JFET) implant 76 may be provided in the JFET gap 74, as discussed in further detail below.

According to one embodiment, the thickness (Ts) of the spreading region 56 is between about 1.5 µm to 10 µm. The first depth (D_{B}) of the base well 64 may be between about 0.5 µm to 1.5 µm. As discussed in further detail below, the thickness (Ts) of the spreading region 56 is two times greater than the first depth (D_{B}) of the base well 64 of each junction implant 58 in order to provide the spreading layer buffer 72, which mitigates the effects of one or more damaged regions located below the junction implants 58.
As an additional example, the thickness (Ts) of the spreading region 56 may be at least 1.5 µm to 10.0 µm greater than the first depth (D_{B}) of the base wells 64, such that the spreading layer buffer 72 is at least 1.5 µm to 10.0 µm.

A gate oxide layer 78 may be positioned on the first surface 60 of the IGBT stack 44, and may extend laterally between a portion of the surface of each one of the source wells 66, such that the gate oxide layer 78 partially overlaps and runs between the surface of each source well 66 in the junction implants 58. The emitter contact 50 may be a "U" shape, and may include two portions in contact with the first surface 60 of the IGBT stack 44. Each portion of the emitter contact 50 on the first surface 60 of the IGBT stack 44 may partially overlap both the source well 66 and the ohmic well 68 of one of the junction implants 58, respectively, without contacting the gate contact 48 of the gate oxide layer 78.

A first junction J₁ between the injector region 52 and the drift region 54, a second junction J₂ between each base well 64 and the drift region 54, and a third junction J₃ between each source well 66 and each base well 64 are controlled to operate in one of a forward-bias mode of operation or a reverse-bias mode of operation based on the biasing of the IGBT device 42. Accordingly, the flow of current between the collector contact 46 and the emitter contact 50 is controlled.

According to one embodiment, the injector region 52 is a highly doped P region 52 with a doping concentration between 1E16 cm⁻³ to 1E21 cm⁻³. The drift region 54 may be a lightly doped N region with a doping concentration between 1E13 cm⁻³ to 1E15 cm⁻³. In some embodiments, the drift region 54 may include a notably light concentration of dopants, in order to improve one or more performance parameters of the IGBT device 42 as discussed in further detail below. The spreading region 56 may be a highly doped N region with a doping concentration between 5E15 cm⁻³ to 5E16 cm⁻³. The spreading region 56 includes a graduated doping concentration, such that as the spreading region 56 extends away from the first surface 60 of the IGBT stack 44, the doping concentration of the spreading region 56 gradually decreases. For example, the portion of the spreading region 56 directly adjacent to the first surface 60 of the IGBT stack 44 may be doped at a concentration of about 5E16 cm⁻³, while the portion of the spreading region directly adjacent to the drift region 54 may be doped at a concentration of about 5E15 cm⁻³. The JFET region 76 may be also be a highly doped N region with a doping concentration between 1E16 cm⁻³ to 1E17 cm⁻³. Further, the base well 64 may be a P doped region with a doping concentration between 5E17 cm⁻³ and 1E19 cm⁻³, the source well 66 may be a highly doped N region with a doping concentration between 1 E19 cm⁻³ and 1 E21 cm⁻³, and the ohmic well 68 may be a highly doped P layer with a doping concentration between 1 E19 cm⁻³ and 1 E21 cm⁻³.

The injector region 52 may be doped aluminum, boron, or the like. Those of ordinary skill in the art will appreciate that many different dopants exist that may be suitable for doping the injector region 52, all of which are contemplated herein. The drift region 54, the spreading region 56, and the JFET region 76 may be doped with nitrogen, phosphorous, or the like. Those of ordinary skill in the art will appreciate that many different dopants exist that may be suitable for doping the drift region 54, the spreading region 56, and the JFET region, all of which are contemplated herein.

According to one embodiment, the injector region 52 is generated by an epitaxy process. According to an additional embodiment, the injector region 52 is formed by an ion implantation process. Those of ordinary skill in the art will appreciate that numerous different processes exist for generating the injector region 52, all of which are contemplated herein. The spreading region 56 and the JFET region 76 may similarly be formed by either an epitaxy process or an ion implantation process. Those of ordinary skill in the art will appreciate that numerous different processes exist for generating the spreading region 56 and the JFET region 76, all of which are contemplated herein.

According to one embodiment, the IGBT stack 44 is a wide band-gap semiconductor material. For example, the IGBT stack 44 may be Silicon Carbide (SiC). As discussed above, manufacturing limitations inherent in current SiC technologies will generally result in a diminished carrier lifetimes and/or carrier concentration in the injector region of a SiC IGBT device. As a result, SiC IGBT devices generally suffer from a reduced amount of "backside injection", which results in poor conductivity modulation and an increased ON resistance (R_{ON}) of the SiC IGBT device. Further, in attempting to design a wide band-gap IGBT device, it was discovered by the inventors that damaged regions below each one of the junction implants of a SiC IGBT device result in a significantly degraded carrier lifetime at or near these damaged regions. These so-called "end-of-range" defects effectively prevent the modulation of current in the upper portion of the drift layer in a SiC IGBT device, which in turn significantly increases the resistance in this area. As a result of the increased resistance in the upper portion of the drift region, current flow in the SiC IGBT device may be significantly reduced, and may even be cut off altogether. The spreading region 56 of the IGBT device 42 is therefore provided to bypass the damaged regions below each one of the junction implants 58, thereby improving the performance of the SiC IGBT device 42.

By bypassing the damaged regions below each one of the junction implants 58, electrons from the emitter contact 50 are delivered directly to a region of high conductivity modulation in the drift region 54. Accordingly, electrons easily pass into the drift region 54 and to the collector contact 46 of the IGBT device 42. Those of ordinary skill in the art will recognize that the ON resistance (R_{ON}) is significantly reduced in the IGBT device 42, thereby improving the performance thereof.

While the spreading region 56 effectively reduces the ON resistance (R_{ON}) of the IGBT device 42, the introduction of the spreading region 56 also results in a decrease in the blocking voltage (V_{BLK}) of the IGBT device 42. In order to compensate for this fact, the doping concentration in the drift region 54 may be decreased, such that the doping concentration in the drift region 54 is exceptionally light, as discussed above. Accordingly, a balance between the on resistance (R_{ON}) and the blocking voltage (V_{BLK}) of the IGBT device 42 may be struck.

In addition to the advantages described above, the IGBT device 42 further benefits from the predominant use of "front-side" injection. That is, the IGBT device 42 shown in Figure 2 transfers current from the collector contact 46 to the emitter contact 50 primarily through the use of electrons supplied from the emitter contact 50, rather than as a result of hole injection from the injector region 52. As will be appreciated by those of ordinary skill in the art, the use of predominant backside injection, as is common among conventional IGBT devices, often results in significant switching losses, thereby degrading the performance of the IGBT device. Accordingly, numerous techniques have been developed to reduce the amount of hole injection provided at the back-side of the device, while simultaneously increasing the amount of electrons supplied from the emitter contact. Due to the arrangement of the various regions in the IGBT stack 44, the IGBT device 42 inherently operates in a predominant "front-side" injection mode, thereby improving the performance of the device.

Further, providing the spreading region 56 also allows the JFET gap width (W_{JFET}) and the overall device width (W_{D}) to be significantly reduced when compared to conventional IGBT devices. For example, the JFET gap width (W_{JFET}) of the IGBT device 42 may be between 1 µm to 4 µm, and the overall device width (W_{D}) of the IGBT device 42 may be between 5 µm to 15 µm.

Finally, providing the spreading region 56 results in desirable thermal properties of the IGBT device 42. As will be appreciated by those of ordinary skill in the art, conventional IGBT devices generally suffer from a significant amount of temperature dependence. That is, the performance characteristics of a conventional IGBT generally change with temperature. Specifically, as the temperature of an IGBT device increases, so does the lifetime of carriers in the drift region, thereby resulting in increased current flow through the device. This can result in a dangerous cycle, in which increased current flow through the IGBT device further raises the temperature of the device, until the IGBT device can no longer handle the amount of current through the device and fails. By providing the spreading region 56 in the IGBT device 42, a large unmodulated region is generated below the first surface 60 of the IGBT stack 44, as discussed above. As will be appreciated by those of ordinary skill in the art, this unmodulated region has an inverse relationship between the current flow therein and temperature. By carefully choosing the dimensions of the drift region 54 and the spreading region 56, a designer can thus effectively cancel the effects of temperature on current flow in the IGBT device 42, thereby significantly increasing the performance thereof.

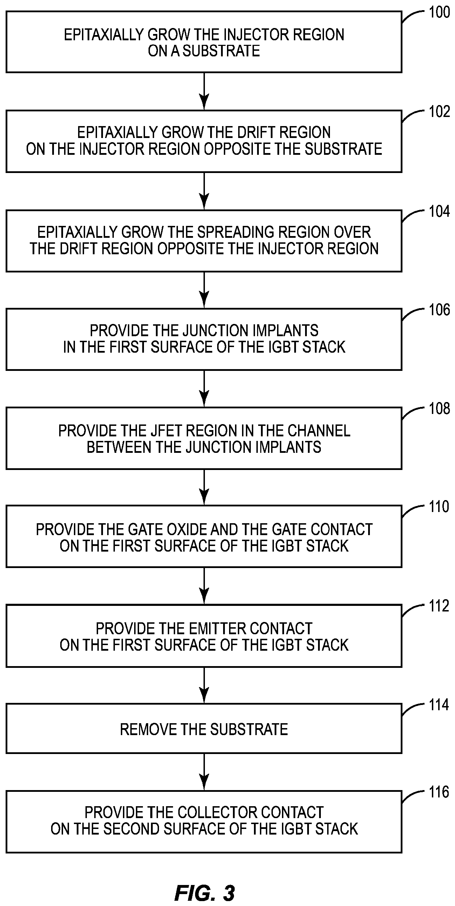

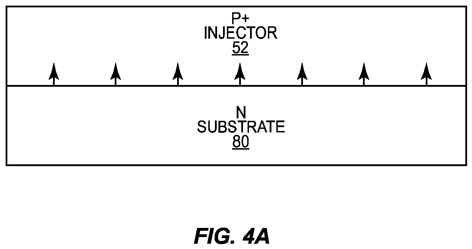

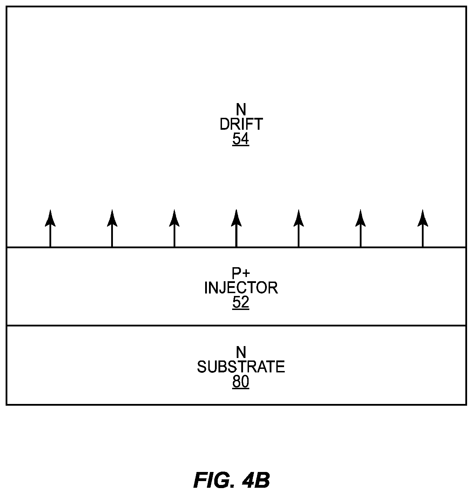

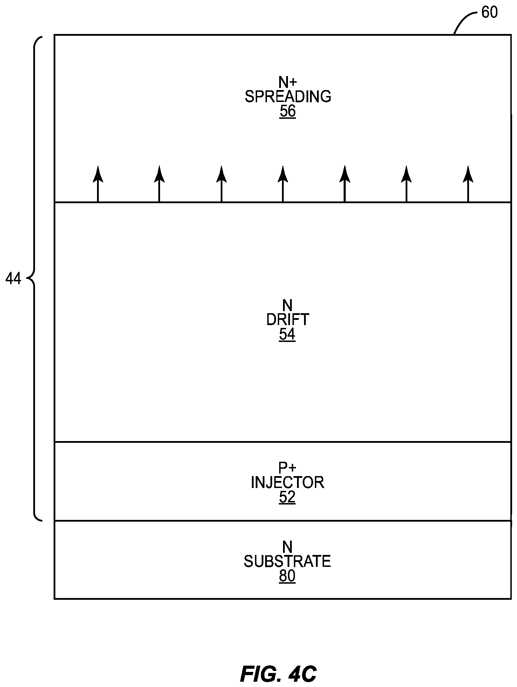

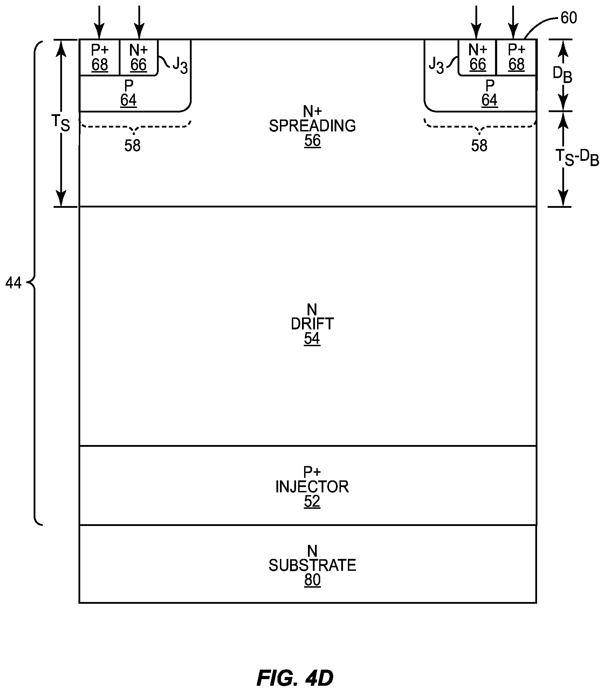

Figures 3 and 4A-4I illustrate a method for manufacturing the IGBT device 42 shown in Figure 2 according to one embodiment of the present disclosure. First, the injector region 52 is grown via an epitaxy process on a sacrificial substrate 80 (step 100 and Figure 4A). As will be appreciated by those of ordinary skill in the art, the sacrificial substrate 80 must be used to generate the IGBT device 42 shown in Figure 2 due to a lack of available P-substrates for SiC materials systems. The drift region 54 is then grown on top of the injector region 52 opposite the substrate 80 (step 102 and Figure 4B). Next, the spreading region 56 is grown via an epitaxy process over the drift region 54 opposite the injector region 52 (step 104 and Figure 4C). The spreading region 56 provides the first surface 60, which is opposite the drift region 54. The junction implants 58 are then provided in the first surface 60 of the IGBT stack 44 (step 106 and Figure 4D), such that the junction implants 58 extend to a first depth D_{B} from the first surface 60 of the IGBT stack 44. The junction implants 58 are generally provided via one or more ion implantation processes, however, any suitable method may be used to provide the junction implants 58 without departing from the principles disclosed herein. Notably, as discussed above, the spreading region 56 and the junction implants 58 are provided such that the spreading region 56 has a thickness Ts that is two times greater than the first depth D_{B}, thereby improving the performance of the completed IGBT device 42.

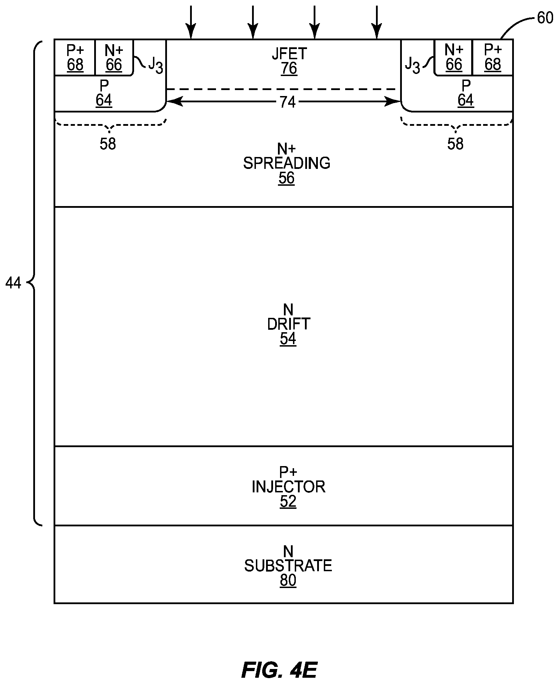

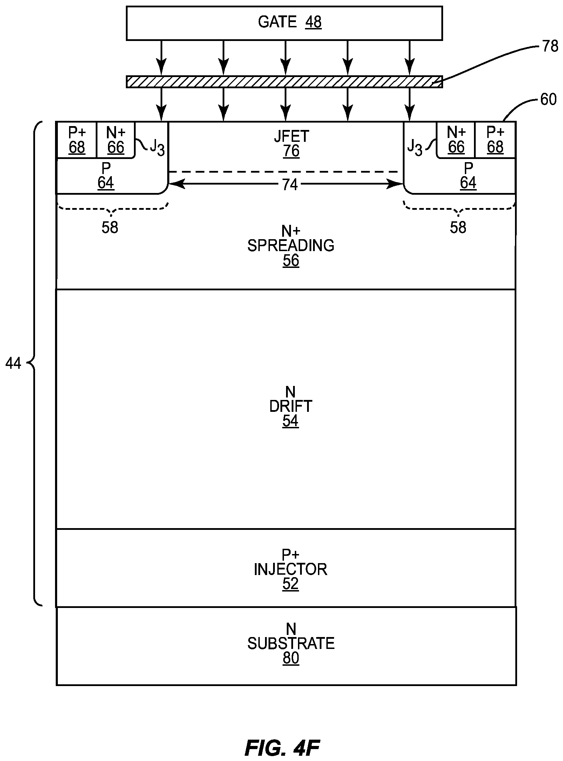

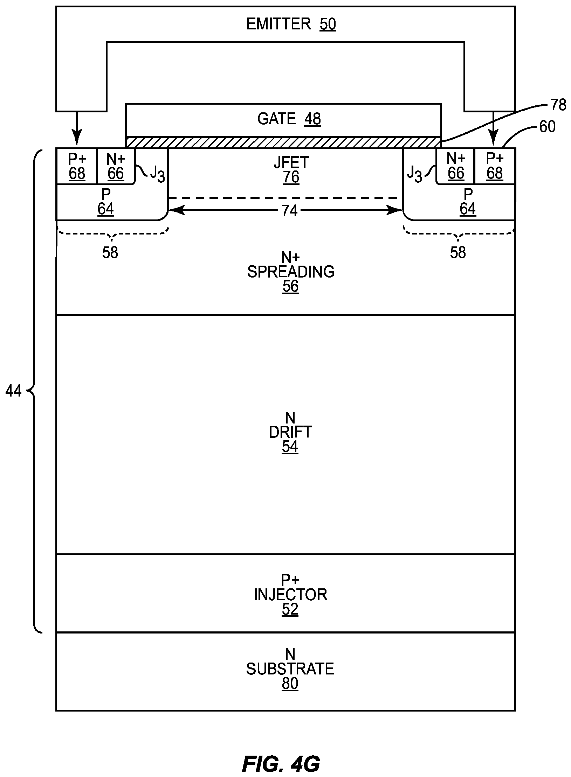

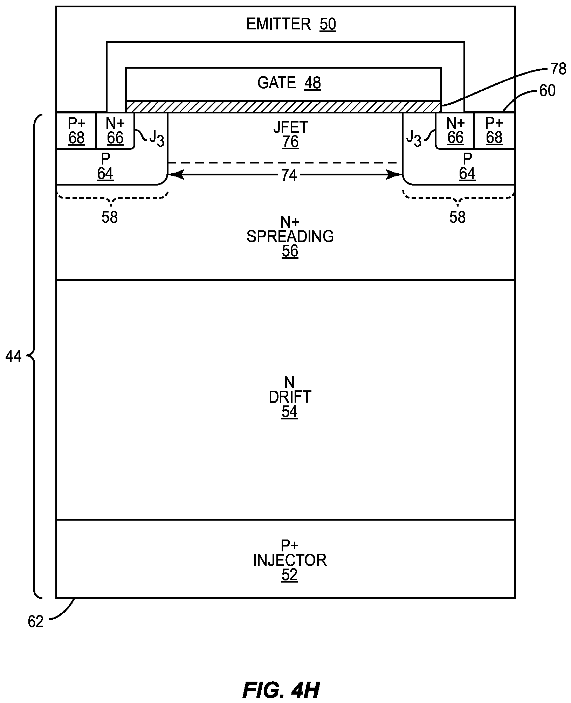

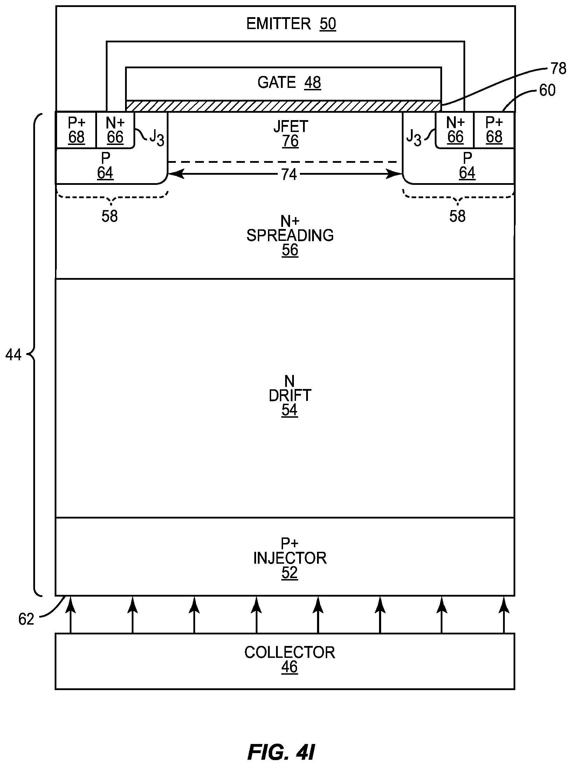

The JFET region 76 is then provided in the channel 74 between the junction implants 58 (step 108 and Figure 4E). The JFET region 76 may be provided by an epitaxy process, an ion implantation process, or any other suitable process. Next, the gate oxide 78 and the gate contact 48 are provided on the first surface 60 of the IGBT stack 44 (step 110 and Figure 4F). Specifically, the gate oxide 78 is provided such that the gate oxide 78 partially overlaps and runs between each source well 66 in the pair of junction implants 58, and the gate contact 48 is provided on top of the gate oxide layer 78. As will be appreciated by those of ordinary skill in the art, several different oxidation and metallization techniques exist for providing the gate oxide 78 and the gate contact 48, respectively, all of which are contemplated herein. The emitter contact 50 is then provided on the first surface 60 of the IGBT stack 44 (step 112 and Figure 4G). Specifically, the emitter contact 50 is provided such that the emitter partially overlaps the source well 66 and the ohmic well 68 in each one of the pair of junction implants 58, respectively, without contacting the gate contact 48. The emitter contact 50 may be provided by any suitable metallization process. Next, the substrate 80 is removed from the IGBT stack 44 (step 114 and Figure 4H). The substrate 80 may be removed, for example, by an etching or grinding process. Finally, the collector contact 46 is provided over the entire second surface 62 of the IGBT stack 44 (step 116 and Figure 4I). The collector contact 46 may be provided by any suitable metallization process.

Although the process illustrated in Figures 3 and 4A-4I is illustrated in a particular number of discrete steps, which are arranged in a particular order, the present disclosure is not so limited. Each illustrated step may in fact comprise one or more steps, and may be accomplished in any order with respect to the other steps without departing from the principles described herein.

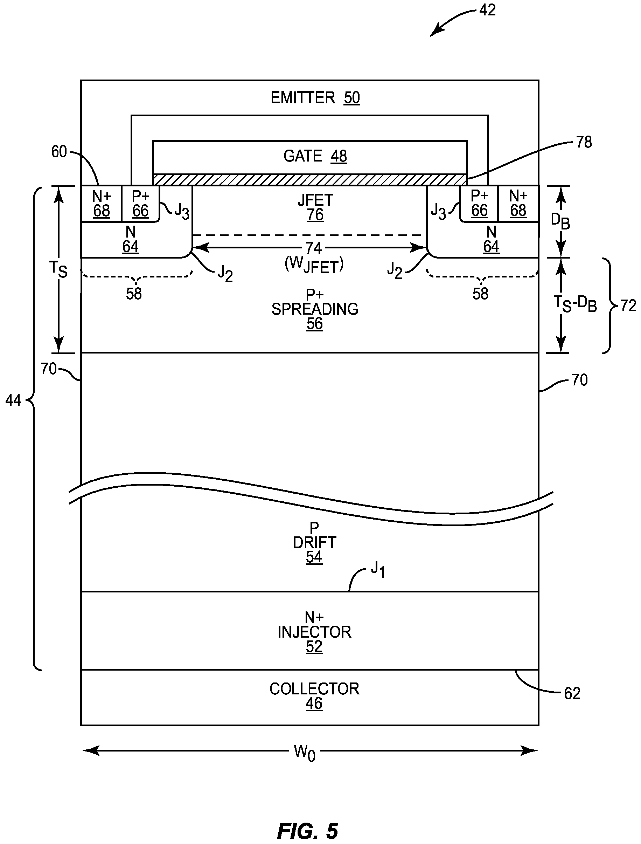

Figure 5 shows the IGBT device 42 according to an additional embodiment of the present disclosure. While the IGBT device 42 shown above with respect to Figure 2 is an N-IGBT, the IGBT device 42 of Figure 5 is a P-IGBT device. Accordingly, the doping of each one of the separate regions in the IGBT device 42 are the opposite of that shown in Figure 2, such that the injector region 52 may be a heavily doped N region with a doping concentration between 1E18 cm⁻³ and 1E21 cm⁻³, the drift region 54 may be a lightly doped P region with a doping concentration between 1E13 cm⁻³ and 1E15 cm⁻³, the spreading region 56 may be a heavily doped P region with a doping concentration between 5E15 cm⁻³ to 5E16 cm⁻³, and the JFET region 76 may be a highly doped P region with a doping concentration between 1E16 cm⁻³ and 1E17 cm⁻³. Further, the base well 64 may be an N doped region with a doping concentration between 5E17 cm⁻³ and 1E19 cm⁻³, the source well 66 may be a highly doped P region with a doping concentration between 1E19 cm⁻³ and 1E21 cm⁻³, and the ohmic well 68 may be a highly doped N layer with a doping concentration between 1E19 cm⁻³ and 1E21 cm⁻³. The IGBT device 42 shown in Figure 5 may function substantially similarly to the IGBT device 42 described above with respect to Figure 2, with differences that will be readily appreciated by those of ordinary skill in the art.

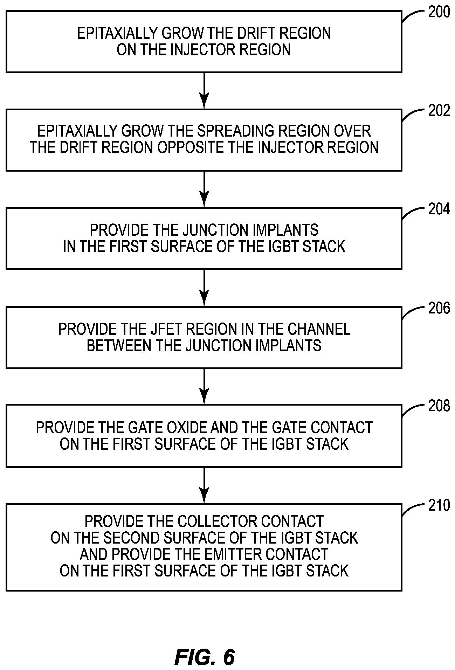

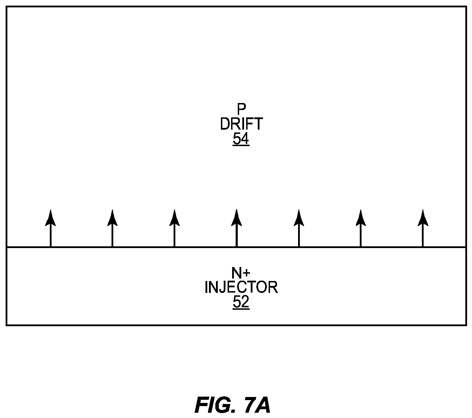

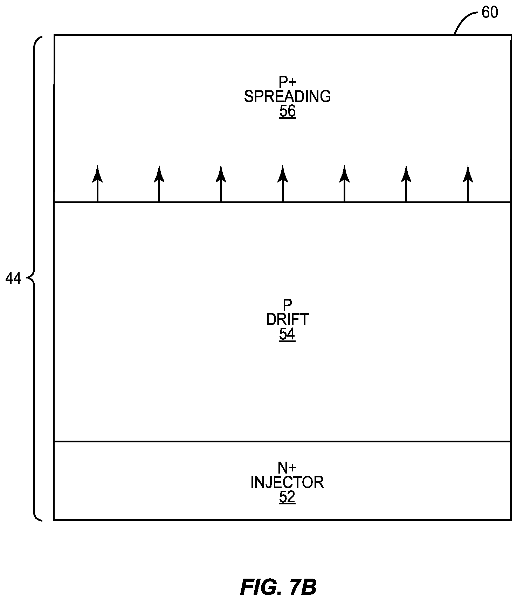

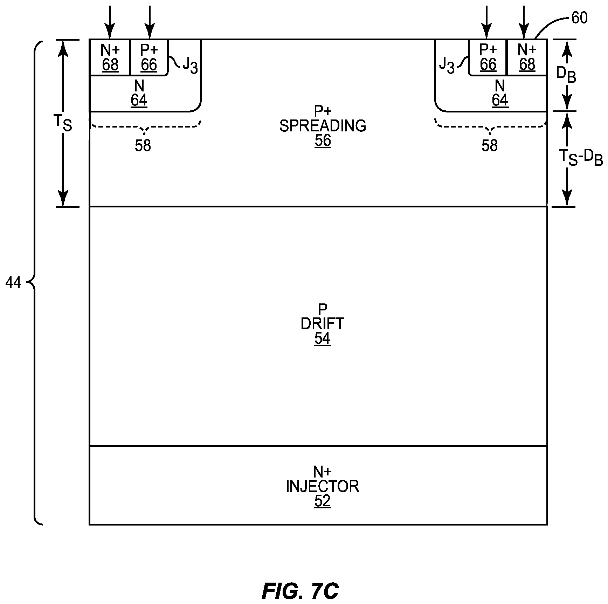

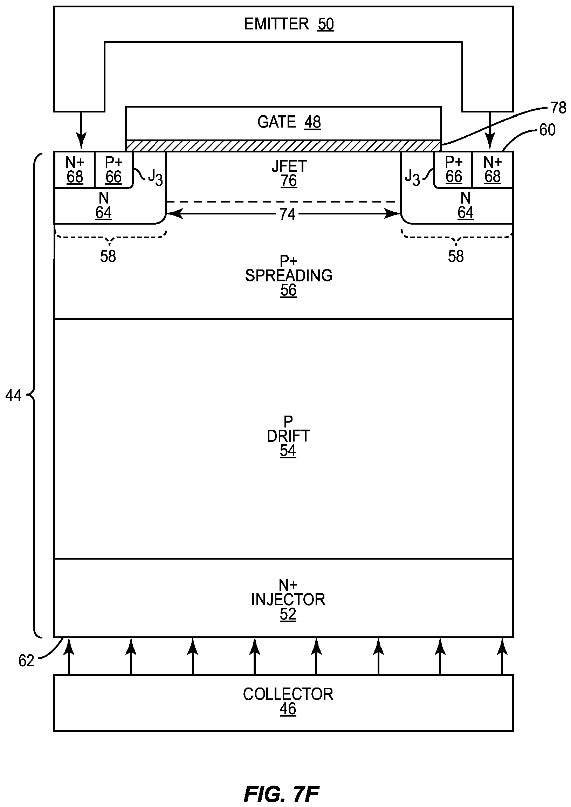

Figures 6 and 7A-7F illustrate a method for manufacturing the IGBT device 42 shown in Figure 5 according to one embodiment of the present disclosure. First, the drift region 54 is grown on top of the injector region 52 (step 200 and Figure 7A). As will be appreciated by those of ordinary skill in the art, because the injector region 52 in the IGBT device 42 is an N-doped layer, the injector region can serve as the substrate for growing the other regions in the IGBT stack 44. The spreading region 56 is then grown on top of the drift region 54 opposite the injector region 52 (step 202 and Figure 7B). The spreading region 56 provides the first surface 60, which is opposite the IGBT stack 44. Next, the junction implants 58 are provided in the first surface 60 of the IGBT stack 44 (step 204 and Figure 7C), such that the junction implants 58 extend to a first depth D_{B} from the first surface 60 of the IGBT stack 44. The junction implants 58 are generally provided via one or more implantation processes, however, any suitable method may be used to provide the junction implants 58 without departing from the principles disclosed herein. Notably, as discussed above, the spreading region 56 and the junction implants 58 are provided such that the spreading region 56 has a thickness Ts that is two times greater than the first depth D_{B}, thereby improving the performance of the completed IGBT device 42.

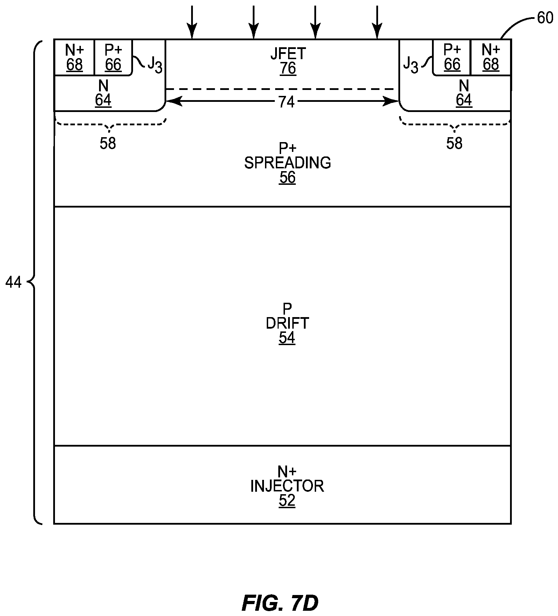

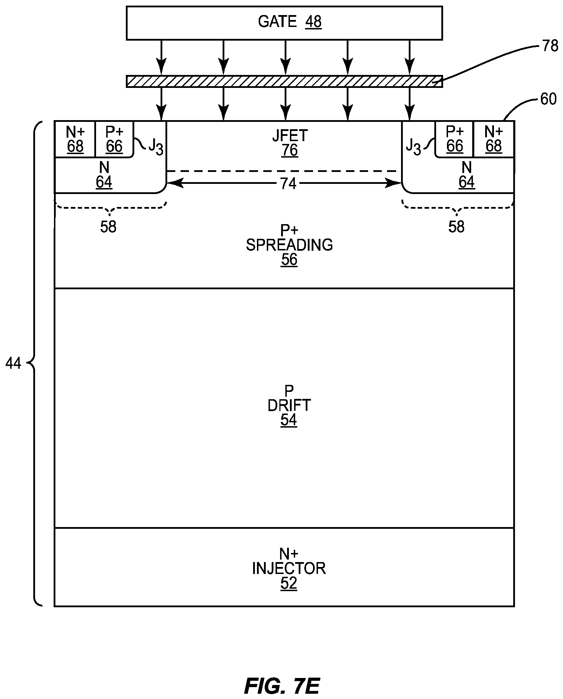

The JFET region 76 is then provided in the channel 74 between the junction implants 58 (step 206 and Figure 7D). The JFET region 76 may be provided by an epitaxy process, an ion implantation process, or any other suitable process. Next, the gate oxide 78 and the gate contact 48 are provided on the first surface 60 of the IGBT stack 44 (step 208 and Figure 7E). Specifically, the gate oxide 78 is provided such that the gate oxide 78 partially overlaps and runs between each source well 66 in the pair of junction implants 58, and the gate contact 48 is provided on top of the gate oxide layer 78. As will be appreciated by those of ordinary skill in the art, several different oxidation and metallization techniques exist for providing the gate oxide 78 and the gate contact 48, respectively, all of which are contemplated herein. Finally, the collector contact 46 is provided on the second surface 62 of the IGBT stack 44, and the emitter contact 50 is provided on the first surface 60 of the IGBT stack 44 (step 210 and Figure 4F). Specifically, the emitter contact 50 is provided such that the emitter contact 50 partially overlaps the source well 66 and the ohmic well 68 in each one of the pair of junction implants, respectively, without contacting the gate contact 48, while the collector contact 46 is provided over the entire second surface 62 of the IGBT stack 44. The collector contact 46 and the emitter contact 50 may be provided by any suitable metallization process.

Although the process illustrated in Figures 6 and 7A-7F is illustrated in a particular number of discrete steps, which are arranged in a particular order, the present disclosure is not so limited. Each illustrated step may in fact comprise one or more steps, and may be accomplished in any order with respect to the other steps without departing from the principles described herein.

Those skilled in the art will recognize improvements and modifications to the preferred embodiments of the present disclosure. All such improvements and modifications are considered within the scope of the concepts disclosed herein and the claims that follow.

## Claims

1. An insulated gate bipolar transistor, IGBT, device (42) comprising:
• an IGBT stack (44), wherein the IGBT stack includes:
• an injector region (52);
• a drift region (54) over the injector region;
• a spreading region (56) over the drift region, the spreading region providing a first surface (60) of the IGBT stack opposite the drift region and having a doping concentration that is greater than a doping concentration of the drift region; and
• a pair of junction implants (58) in the spreading region, wherein:
• the pair of junction implants are separated by a gap (74) and extend from the first surface of the IGBT stack along a lateral edge of the IGBT stack towards the drift region to a first depth (D_{B}); and
• the thickness (Ts) of the spreading region is at least two times greater than the first depth (D_{B});
• a gate contact (48) and an emitter contact (50) on the first surface of the IGBT stack; and
• a collector contact (46) on a second surface of the IGBT stack, which is provided by the injector region opposite the drift region,
**characterized in that**
the doping concentration of the spreading region includes a graduated doping concentration which is higher adjacent the first surface than adjacent the drift region.

2. The IGBT device of claim 1 wherein the IGBT stack is a wide band-gap semiconductor material.

3. The IGBT device of claim 1 wherein the IGBT stack is Silicon Carbide, SiC.

4. The IGBT device of claim 1 wherein each one of the pair of junction implants comprises:
• a base well (64);
• a source well (66); and
• an ohmic well (68), wherein the doping concentration of the base well, the source well, and the ohmic well are different from one another.

5. The IGBT device of claim 4 wherein:
• the gate contact partially overlaps and runs between each source well in the pair of junction implants; and
• the emitter contact partially overlaps both the source well and the ohmic well in each one of the pair of junction implants, respectively, without contacting the gate contact.

6. The IGBT device of claim 5 further comprising a gate oxide layer (78) between the gate contact and the first surface of the IGBT stack.

7. The IGBT device of claim 1 wherein:
• the drift region is an N region with a doping concentration between 1×10¹³ cm⁻³ and 1×10¹⁵ cm⁻³;
• the injector region is a P region with a doping concentration between 1×10¹⁶ cm⁻³ and 1×10²¹ cm⁻³; and
• the spreading region is an N region with a doping concentration between 5×10¹⁵ cm⁻³ and 5×10¹⁶ cm⁻³.

8. The IGBT device of claim 1 wherein:
• the drift region is a P region with a doping concentration between 1×10¹³ cm⁻³ and 1×10¹⁵ cm⁻³;
• the injector region is an N region with a doping concentration between 1×10¹⁸ cm⁻³ and 1×10²¹ cm⁻³; and
• the spreading region is a P region with a doping concentration between 5×10¹⁵ cm⁻³ and 5×10¹⁶ cm⁻³.

9. The IGBT device of claim 1 wherein:
• the first depth is in the range of 0.3 µm to 1.0 µm; and
• the thickness of the spreading region is in the range of 1.5 µm to 10 µm.

10. The IGBT device of claim 1 wherein a width of the IGBT stack is between 1µm to 4µm.

11. A method comprising:
• providing (100-104) an IGBT stack including an injector region, a drift region over the injector region, and a spreading region over the drift region, such that the spreading region provides a first surface of the IGBT stack opposite the drift layer and the spreading region has a doping concentration that is greater than a doping concentration of the drift region;
• providing (106) a pair of junction implants in the first surface of the IGBT stack such that the pair of junction implants are separated by a gap (74) and extend from the first surface of the IGBT stack towards the drift region to a first depth (D_{B}), wherein the thickness (Ts) of the spreading region is at least two times greater than the first depth;
• providing (110, 112) a gate contact and an emitter contact on the first surface of the IGBT stack; and
• providing (116) a collector contact on a second surface of the IGBT stack, which is provided by the injector region opposite the drift region,
**characterized in that**
the doping concentration of the spreading region includes a graduated doping concentration which is higher adjacent the first surface than adjacent the drift region.

12. The method of claim 11 wherein the IGBT stack is Silicon Carbide, SiC.

## Patentansprüche

1. Eine Insulated-Gate-Bipolar-Transistor(Bipolartransistor mit isolierter Gateelektrode)-Vorrichtung, IGBT-Vorrichtung (42), die Folgendes beinhaltet:
• einen IGBT-Stapel (44), wobei der IGBT-Stapel Folgendes umfasst:
µ eine Injektorregion (52);
µ eine Driftregion (54) über der Injektorregion;
• eine Ausbreitungsregion (56) über der Driftregion, wobei die Ausbreitungsregion eine erste Oberfläche (60) des IGBT-Stapels gegenüber der Driftregion bereitstellt und eine Dotierungskonzentration aufweist, die größer als eine Dotierungskonzentration der Driftregion ist; und
• ein Paar Übergangsimplantate (58) in der Ausbreitungsregion, wobei:
• das Paar Übergangsimplantate durch eine Lücke (74) getrennt ist und sich von der ersten Oberfläche des IGBT-Stapels entlang einer Seitenkante des IGBT-Stapels in Richtung der Driftregion bis zu einer ersten Tiefe (D_{B}) erstreckt; und
• die Dicke (Ts) der Ausbreitungsregion mindestens zweimal so groß wie die erste Tiefe (D_{B}) ist;
• einen Gatekontakt (48) und einen Emitterkontakt (50) auf der ersten Oberfläche des IGBT-Stapels; und
• einen Kollektorkontakt (46) auf einer zweiten Oberfläche des IGBT-Stapels, die von der Injektorregion gegenüber der Driftregion bereitgestellt wird,
**dadurch gekennzeichnet, dass**
die Dotierungskonzentration der Ausbreitungsregion eine abgestufte Dotierungskonzentration umfasst, die angrenzend an die erste Oberfläche höher als angrenzend an die Driftregion ist.

2. IGBT-Vorrichtung gemäß Anspruch 1, wobei der IGBT-Stapel ein Breitbandlückenhalbleitermaterial ist.

3. IGBT-Vorrichtung gemäß Anspruch 1, wobei der IGBT-Stapel Siliciumcarbid, SiC, ist.

4. IGBT-Vorrichtung gemäß Anspruch 1, wobei jedes des Paares Übergangsimplantate Folgendes beinhaltet:
• eine Basiswanne (64);
• eine Quellwanne (66); und
• eine ohmsche Wanne (68), wobei sich die Dotierungskonzentrationen der Basiswanne, der Quellwanne und der ohmschen Wanne voneinander unterscheiden.

5. IGBT-Vorrichtung gemäß Anspruch 4, wobei:
• der Gatekontakt jede Quellwanne in dem Paar Übergangsimplantate teilweise überlappt und dazwischen verläuft; und
• der Emitterkontakt sowohl die Quellwanne als auch die ohmsche Wanne in jedem des Paars Übergangsimplantate jeweils überlappt, ohne den Gatekontakt zu berühren.

6. IGBT-Vorrichtung gemäß Anspruch 5, die ferner eine Gateoxidschicht (78) zwischen dem Gatekontakt und der ersten Oberfläche des IGBT-Stapels beinhaltet.

7. IGBT-Vorrichtung gemäß Anspruch 1, wobei:
• die Driftregion eine N-Region mit einer Dotierungskonzentration zwischen 1×10¹³ cm⁻³ und 1×10¹⁵ cm⁻³ ist;
• die Injektorregion eine P-Region mit einer Dotierungskonzentration zwischen 1×10¹⁶ cm⁻³ und 1×10²¹ cm⁻³ ist; und
• die Ausbreitungsregion eine N-Region mit einer Dotierungskonzentration zwischen 5×10¹⁵ cm⁻³ und 5×10¹⁶ cm⁻³ ist.

8. IGBT-Vorrichtung gemäß Anspruch 1, wobei:
• die Driftregion eine P-Region mit einer Dotierungskonzentration zwischen 1×10¹³ cm⁻³ und 1×10¹⁵ cm⁻³ ist;
• die Injektorregion eine N-Region mit einer Dotierungskonzentration zwischen 1×10¹⁸ cm⁻³ und 1×10²¹ cm⁻³ ist; und
• die Ausbreitungsregion eine P-Region mit einer Dotierungskonzentration zwischen 5×10¹⁵ cm⁻³ und 5×10¹⁶ cm⁻³ ist.

9. IGBT-Vorrichtung gemäß Anspruch 1, wobei:
• die erste Tiefe im Bereich von 0,3 µm bis 1,0 µm liegt; und
• die Dicke der Ausbreitungsregion im Bereich von 1,5 µm bis 10 µm liegt.

10. IGBT-Vorrichtung gemäß Anspruch 1, wobei eine Breite des IGBT-Stapels zwischen 1 µm und 4 µm liegt.

11. Ein Verfahren, das Folgendes beinhaltet:
• Bereitstellen (100-104) eines IGBT-Stapels, der eine Injektorregion, eine Driftregion über der Injektorregion und eine Ausbreitungsregion über der Driftregion umfasst, sodass die Ausbreitungsregion eine erste Oberfläche des IGBT-Stapels gegenüber der Driftschicht bereitstellt und die Ausbreitungsregion eine Dotierungskonzentration aufweist, die größer als eine Dotierungskonzentration der Driftregion ist;
• Bereitstellen (106) eines Paares Übergangsimplantate in der ersten Oberfläche des IGBT-Stapels, sodass das Paar Übergangsimplantate durch eine Lücke (74) getrennt ist und sich von der ersten Oberfläche des IGBT-Stapels in Richtung der Driftregion bis zu einer ersten Tiefe (D_{B}) erstreckt, wobei die Dicke (Ts) der Ausbreitungsregion mindestens zweimal so groß wie die erste Tiefe ist;
• Bereitstellen (110, 112) eines Gatekontakts und eines Emitterkontakts auf der ersten Oberfläche des IGBT-Stapels; und
• Bereitstellen (116) eines Kollektorkontakts auf einer zweiten Oberfläche des IGBT-Stapels, die von der Injektorregion gegenüber der Driftregion bereitgestellt wird,
**dadurch gekennzeichnet, dass**
die Dotierungskonzentration der Ausbreitungsregion eine abgestufte Dotierungskonzentration umfasst, die angrenzend an die erste Oberfläche höher als angrenzend an die Driftregion ist.

12. Verfahren gemäß Anspruch 11, wobei der IGBT-Stapel Siliciumcarbid, SiC, ist.

## Revendications

1. Un dispositif-transistor bipolaire à grille isolée, IGBT, (42) comprenant :
• un empilement IGBT (44), l'empilement IGBT incluant :
• une région d'injecteur (52) ;
• une région de migration (« drift ») (54) par-dessus la région d'injecteur ;
• une région d'étalement (56) par-dessus la région de migration, la région d'étalement apportant une première surface (60) de l'empilement IGBT à l'opposé de la région de migration et ayant une concentration de dopage qui est plus grande qu'une concentration de dopage de la région de migration ; et
• une paire d'implants de jonction (58) dans la région d'étalement, où :
• les implants de la paire d'implants de jonction sont séparés par un espace (74) et s'étendent depuis la première surface de l'empilement IGBT le long d'un bord latéral de l'empilement IGBT en direction de la région de migration jusqu'à une première profondeur (D_{B}) ; et
• l'épaisseur (Ts) de la région d'étalement est au moins deux fois plus grande que la première profondeur (D_{B}) ;
• un contact de grille (48) et un contact d'émetteur (50) sur la première surface de l'empilement IGBT ; et
• un contact de collecteur (46) sur une deuxième surface de l'empilement IGBT, laquelle est apportée par la région d'injecteur à l'opposé de la région de migration,
**caractérisé en ce que**
la concentration de dopage de la région d'étalement inclut une concentration de dopage graduée qui est plus élevée dans la zone adjacente à la première surface que dans celle adjacente à la région de migration.

2. Le dispositif IGBT de la revendication 1 où l'empilement IGBT est un matériau semiconducteur à large bande interdite.

3. Le dispositif IGBT de la revendication 1 où l'empilement IGBT est du carbure de silicium, SiC.

4. Le dispositif IGBT de la revendication 1 où chaque implant de la paire d'implants de jonction comprend :
• un puits de base (64) ;
• un puits de source (66) ; et
• un puits ohmique (68), où la concentration de dopage du puits de base, du puits de source, et du puits ohmique sont différentes l'une de l'autre.

5. Le dispositif IGBT de la revendication 4 où :
• le contact de grille recouvre partiellement et relie chaque puits de source dans la paire d'implants de jonction ; et
• le contact d'émetteur recouvre partiellement à la fois le puits de source et le puits ohmique dans chaque implant de la paire d'implants de jonction, respectivement, sans toucher le contact de grille.

6. Le dispositif IGBT de la revendication 5 comprenant en outre une couche d'oxyde de grille (78) entre le contact de grille et la première surface de l'empilement IGBT.

7. Le dispositif IGBT de la revendication 1 où :
• la région de migration est une région N présentant une concentration de dopage comprise entre 1 × 10¹³ cm⁻³ et 1 × 10¹⁵ cm⁻³ ;
• la région d'injecteur est une région P présentant une concentration de dopage comprise entre 1 × 10¹⁶ cm⁻³ et 1 × 10²¹ cm⁻³ ; et
• la région d'étalement est une région N présentant une concentration de dopage comprise entre 5 × 10¹⁵ cm⁻³ et 5 × 10¹⁶ cm⁻³.

8. Le dispositif IGBT de la revendication 1 où :
• la région de migration est une région P présentant une concentration de dopage comprise entre 1 × 10¹³ cm⁻³ et 1 × 10¹⁵ cm⁻³ ;
• la région d'injecteur est une région N présentant une concentration de dopage comprise entre 1 × 10¹⁸ cm⁻³ et 1 × 10²¹ cm⁻³ ; et
• la région d'étalement est une région P présentant une concentration de dopage comprise entre 5 × 10¹⁵ cm⁻³ et 5 × 10¹⁶ cm⁻³.

9. Le dispositif IGBT de la revendication 1 où :
• la première profondeur est comprise dans l'intervalle allant de 0,3 µm à 1,0 µm ; et
• l'épaisseur de la région d'étalement est comprise dans l'intervalle allant de 1,5 µm à 10 µm.

10. Le dispositif IGBT de la revendication 1 où une largeur de l'empilement IGBT fait de 1 µm à 4 µm.

11. Un procédé comprenant :
• l'apport (100-104) d'un empilement IGBT incluant une région d'injecteur, une région de migration par-dessus la région d'injecteur, et une région d'étalement par-dessus la région de migration, de sorte que la région d'étalement apporte une première surface de l'empilement IGBT à l'opposé de la région de migration et que la région d'étalement a une concentration de dopage qui est plus grande qu'une concentration de dopage de la région de migration ;
• l'apport (106) d'une paire d'implants de jonction dans la première surface de l'empilement IGBT de sorte que les implants de la paire d'implants de jonction sont séparés par un espace (74) et s'étendent depuis la première surface de l'empilement IGBT en direction de la région de migration jusqu'à une première profondeur (D_{B}), l'épaisseur (Ts) de la région d'étalement étant au moins deux fois plus grande que la première profondeur ;
• l'apport (110, 112) d'un contact de grille et d'un contact d'émetteur sur la première surface de l'empilement IGBT ; et
• l'apport (116) d'un contact de collecteur sur une deuxième surface de l'empilement IGBT, laquelle est apportée par la région d'injecteur à l'opposé de la région de migration,
**caractérisé en ce que**
la concentration de dopage de la région d'étalement inclut une concentration de dopage graduée qui est plus élevée dans la zone adjacente à la première surface que dans celle adjacente à la région de migration.

12. Le procédé de la revendication 11 où l'empilement IGBT est du carbure de silicium, SiC.
